# EUROPEAN PATENT SPECIFICATION

(11) **EP 2 368 282 B1**
(45) Date of publication and mention of the grant of the patent: **25.03.2015**
(21) Application number: 09756677.2
(22) Date of filing: 18.11.2009
(51) Int. Cl.: C23C 14/10, C23C 14/46, H01L 21/56, H01L 51/52

(54) **PROCESS OF FORMING PROTECTING LAYER BY PARTICLES HAVING LOW ENERGY**
HERSTELLUNG EINER SCHUTZSCHICHT DURCH PARTIKEL NIEDRIGER ENERGIE
PROCESSUS DE FORMATION DE COUCHE PROTECTRICE AU MOYEN DE PARTICULES AYANT UNE FAIBLE ÉNERGIE

(30) Priority: 18.12.2008 EP 08021957
(43) Date of publication of application: 28.09.2011
(73) Proprietor: Merck Patent GmbH, 64293 Darmstadt (DE)
(72) Inventor: COELLE, Michael, 45721 Haltern am See (DE); PARRI, Owain, Llyr, Hampshire BH24 3AN (GB); SPARROWE, David, Bournemouth BH6 3BB (GB); YAROSHCHUK, Oleg, Kiev 03110 (UA); TELESH, Eugene, Minsk, 220113 (BY)
(86) International application number: PCT/EP2009/008197
(87) International publication number: WO 2010/069443

(56) References cited:
- WO-A1-2009/106208
- US-A1- 2007 172 696
- US-B1- 6 559 593
- ANDERS ET AL: "Plasma and ion sources in large area coating: A review" SURFACE AND COATINGS TECHNOLOGY, ELSEVIER, AMSTERDAM, NL, vol. 200, no. 5-6, 21 November 2005 (2005-11-21), pages 1893-1906, XP005173240 ISSN: 0257-8972

## Description

### Field of the Invention

The invention relates to a process of providing passivation, protection or encapsulation layers, in an organic electronic device by a low energy particle beam deposition process.

### Background and Prior Art

Protection layers are needed for organic electronic (OE) devices. The two main applications are the following:
- passivation of a functional layer for the next process steps during device manufacture, and
- encapsulation, in particular for protection against water and oxygen.

There is a great demand for good protection layers. Organic materials, which are typically used in prior art for this purpose, are usually soft and suffer from their intrinsic permeability for water and oxygen. Up to date no satisfying solution has been reported in prior art for providing a robust protection and/or passivation layer on top of OE devices like organic field effect transistors (OFETs).

In view of this, great attention is paid to inorganic functional coatings. However, the plasmochemical deposition methods hitherto known in prior art, like CVD (chemical vapour deposition) and PECVD (plasma enhanced CVD), are not suitable for producing inorganic coatings or layers on organic materials, because of the high temperatures and the aggressive components of the plasma, which are harmful for organic electronic mateials. The pulsed plasma deposition as disclosed for example in US 2005/0181535 A1 may only partially solve this problem.

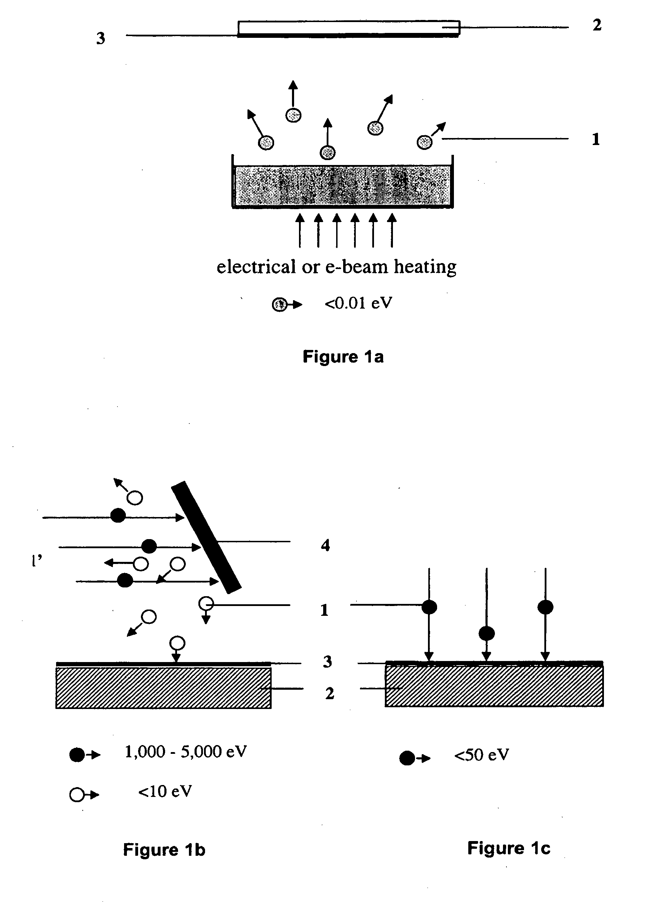

More "friendly" processes for the deposition of inorganic particles on organic structures are associated with particle fluxes or particle beams. The term "particles" as used hereinafter includes ions, radicals, neutral molecules and atoms, or mixtures thereof. The most general classification of particle deposition methods is exemplarily and schematically illustrated in **Figure 1****.** One can select three fundamental particle beam deposition processes:
1) vapour deposition (VD),
2) sputtering deposition (SD),
3) direct deposition (DD).

In case of process 1), as shown in **Figure 1a****,** a coating material is transferred to a vapour phase by electrical or e-beam heating. A flux of vapour (1) reaches the substrate (2) and condenses on it, thereby forming a coating (3).

In case of process 2), as shown in **Figure** 1**b****,** if a beam of accelerated ions or plasma (1') having an energy of several keV is directed to a first substrate (4), also known as "target", it causes material ablation from the target. The extracted particles (1) have a much lower energy and can be deposited on a desired second substrate (2) to form a film (3). This process is known as ion beam sputtering deposition.

In case of process 3), as shown in **Figure 1c****,** if a beam of particles (1) having low energy (far less than 100 eV) is directed immediately to the substrate (2), the particles condense and react on the substrate forming a permanent film (3). This process is hereinafter referred to as direct (particle beam) deposition.

The deposition processes above can be divided into processes of physical and chemical deposition. The latter ones including reactions between particles forming the coating result in formation of covalent bonds. The corresponding above-mentioned processes 1) and 2) are usually called chemical vapour deposition (CVD) and reactive sputtering. They are initialized by heating substrates or insertion of reactive components in the particle fluxes producing coatings. The process of direct plasma deposition is naturally a chemical process.

The deposition processes described above can additionally be assisted or enhanced by plasma or ions. The term "plasma assisted" usually means that in a course of deposition the coatings are treated by a beam of accelerated particles with the energy being lower than the energy needed for effective ablation of the deposited films. The term "plasma enhanced" means that particles forming the film are subjected to plasma discharge. These additional processes are involved for several reasons:
to enhance reactivity of the species forming the coating,
to improve adhesion of the coating to the substrate, and
to densify the coating.

The assistance is especially effective for vapour deposition, which otherwise yields usually only low density coatings.

The deposition processes can also be considered from the viewpoint of predominating particles energy. In a vapour deposition process the particle energy is typically of the order of kT, i.e., several milli electron volts. In an ion beam sputtering deposition it is typically of the order of eV or tens of eV. In a direct deposition process it is typically equal to tens of eV. Different particle energy in these processes results in different morphology of the coatings. Usually the density of the coatings increases with the particle energy. This means that the particles after deposition still have some kinetic energy allowing them to migrate on the surface. This increases the probability of particle trapping in cavities that are present in the coating formed. At the same time, however, the particle energy should not exceed a critical value, which is usually in the range of several hundreds eV, because then the etching (or ablation) process will predominate over deposition.

Coating inorganic films onto organic electronic layers implies additional requirements. On the one hand, the particle energy should be high enough to form a dense film. On the other hand, the energy growth increases the risk of destruction of the organic layer. On account of this, passivation of OE layers is usually provided by a vapour deposition process operating with particles of lowest energy. However, this prior art deposition method results in coatings of rather low density, which exhibit for example only poor gas barrier properties.

Therefore, to increase the density of vapour deposited films, plasma enhanced and particle beam assisted vapour deposition processes have been proposed in prior art. For example, US 7,163,721 claims a method of plasma enhanced thermal chemical vapour deposition (PECVD), wherein the material is heated and evaporated. The vapour is subjected to plasma discharge that enhances both the particle reactivity and the particle energy. The first one allows to reduce temperature, while the second one makes the coated film denser. According to US 7,163,721 a two-step process is employed: First a protective, quite porous, layer is deposited by CVD technique, then a denser layer is deposited using a plasma assisted process. The first, protective layer is needed to protect the organic coating from plasma action destructive for organic electronics, the second, denser layer is needed to cover the pores of the first layer in order to better isolate the organic layer. As a modification of this process US 7,163,721 suggests using vapour deposition with a soft plasma assistance and then with a strong plasma assistance to produce the dense layer (plasma enhanced atomic layer deposition, PEALD).

US 2007/0172696 A1 claims an ion assisted vapour deposition process. The ion beam is used to enhance the particle's reactivity and compress the coating.

However, these prior art enhanced and assisted VD processes do not completely exclude the bombardment of OE layers with particles of high energy and high reactivity, which retains a rather high level of risk of damaging the OE structures. Moreover, these processes are rather complicated, because they include several various particle sources and several deposition steps. This limits the productivity and increases the production costs.

Surface & Coatings Technology 200 (2005) 1893-1906 shows end Hall sources as suited for energetic beams > 100 eV.

Thus there is still a need for a method to deposit a dense protection layer, onto the organic layer of an OE device, which does not harm the organic layer and has no or only minor negative impact on the device performance.

It is therefore an aim of the present invention to provide a method for producing a passivation, encapsulation or protection layer onto an OLED, an OFET or an organic photovoltaic (OPV) device, wherein said method does not harm the organic layer, has no or only minor negative impact on the device performance, is time- and cost-effective, is suitable for mass production, and does not have the drawbacks of the prior art methods described above. Other aims of the present invention are immediately evident to the person skilled in the art from the following detailed description.

It was found that these aims can be achieved by using a deposition process, where the predominating kinetic energy of the particles forming the deposited layer has been thoroughly optimized. The optimized energy range for OE layers in the process of this invention as claimed in claim 1 was established to be in the range from 0.1 to 30 eV. The upper limit of the energy range is still endurable for OE structures, while the lower limit still provides coatings with acceptable uniformity, density, adhesion and durability. This optimized range of the particle energy can be achieved by appropriate selection of the particle source -an end Hall source- and the processing conditions. In addition, the method claimed in this invention has the advantage that it is very simple and effective, especially for large scale production, as it requires only one deposition step and allows the use of standard particle beam sources.

### Terms and Definitions

The term "particle beam" means a beam of neutral molecules and atoms, ions, radicals, or mixtures thereof such as plasma.

The term "accelerated particle beam" in prior art usually means a beam of particles generated by a particle source which have obtained acceleration (usually by electrostatic fources) before or after leaving the particle source. In prior art there is no well established terminology of accelerated particle beams. Usually all of them are referred to as ion beams because only the ion component of the particle beam gets acceleration. However, more precise definitions are given below, taking into account the difference in the extraction of particle beams from the plasma discharge area.

The term "plasma beam" or "accelerated plasma beam" means a particle beam formed immediately in a glow discharge and pushed out of the discharge area by the electric field, usually by a high anode potential.

The term "ion beam" means an ion flux extracted from the glow discharge, commonly by a system of grids. In this case, the glow discharge area and the formed beam are spatially separeted.

The term "particle energy" means the kinetic energy of individual particles. Depending on the particle source, particles have narrow or broad energy distribution. The particle energy corresponding to a maximum of energy distribution will be called "predominating particle energy".

The term "weakly accelerated particles" or "particles with low predominating particle energy" means particles having a low predominating energy >0.01 eV, preferably >0.05 eV, more preferably >0.1eV and most preferably >0.5 eV, and <150 eV, more preferably <80 eV and most preferably <40 eV or even < 30 eV.

The term "moderately accelerated particles" means that the particles have a moderate predominating energy >100 eV, preferably >1000 eV and the most preferably >2000 eV and <10000 eV, more preferably <5000 eV and the most preferably <4000 eV.

The term "anode layer source" means a particle beam source from the family of Hall sources generating fluxes of moderately accelerated plasma with a broad distribution of particle's energy, the maximal particle energy being considerably lower than 10,000 eV, and a maximum of energy distribution at 2/3 of the maximal energy. This source is usually used for particle beam etching and sputtering deposition. In case of sputtering deposition the beam of moderately accelerated plasma (primary beam) is directed on the target. The extracted particles of the target with an energy of several eV form a secondary particle beam, which is directed onto the substrate. The anode layer source in both etching and sputtering regimes may operate with non-reactive and reactive gases or mixtures thereof. The details of construction of this source, working principle and operation parameters can be found in V. Zhurin, H. Kaufman, R. Robinson, Plasma Sources Sci. Technol., 8, p. 1, 1999.

The term "end Hall source" means a particle beam source from the family of Hall sources generating fluxes of weakly accelerated plasma with a broad distribution of particle's energy, a maximal particle energy less than 150 eV and a maximum of energy distribution at 2/3 of the maximal energy. The feed gas of this source necessarily includes reactive components. This source is usually used for direct deposition, particle beam assistance in film deposition and surface cleaning. To realize deposition, the feed gas of the source necessarily includes reactive components. The assistance and cleaning functions are usually realized by plasmas of non-reactive gases. The details of construction of this source, working principle and operation parameters can be found, for example, in US 4,862,032.

The term "reactive particles" means that the particles are capable to react chemically with other particles on the substrate resulting in film deposition. The gases whose plasmas produce reactive particles are called "reactive gases". Examples of these gases are hydrocarbon gases (such as CH₄, C₂H₆ or C₂H₂), SiH₄, N₂ and O₂.

The term "non-reactive particles" means particles which do not react (or poorly react) with other particles. Having sufficient acceleration, these particles cause physical etching of a substrate rather than film deposition. The gases providing non-reactice particles are referred to as "non-reactive" gases. Examples of these gases are rare gases such as Ar, Xe, Kr etc.

The terms "SiOₓ", "SiOₓN_{y}", "SiNₓ", "AlOₓ", "a-C:H", etc. mean silicon oxide, silicon oxynitride, silicon nitride, aluminium oxide, amorphous hydrogenated carbon, etc. or films or coatings thereof.

The term "thin film" means a film having a thickness in the range from several nm to several µm, in case of OE functional layers usually in the range from 1 nm to 2 µm, preferably from 10 nm to 1 µm.

The term "film" and "layer" include rigid or flexible, self-supporting or freestanding films with mechanical stability, as well as coatings or layers on a supporting substrate or between two substrates.

The term "passivation layer (or film)" refers to the layer on an OE device or a component thereof which makes this OE device or component inert (passive) with regard to environmental influence.

The term "encapsulation layer (or film)" refers to the layer protecting an OE device or a component thereof from aggressive external factors like humidity and oxygen. Synonymes of this term are "barrier layer" or "packaging layer".

The term "protection layer (or film)" as used above and below includes both passivation and encapsulation layers, and means a layer that serves as barrier or protection against environmental influence like for example water, gases like oxygen, or mechanical stress.

The term "alignment layer (or film)" means a layer for the alignment of molecules of components of OE devices, or of liquid crystal (LC) molecules in LC devices or OE devices.

The term "functional layer (or film)" means a film or layer in an OE device which has one or more specific functions, like for example protection, passivation, encapsulation and/or alignment function.

### Summary of the Invention

The invention relates to a process of providing a protection, passivation or encapsulation layer on an organic field effect transistor (OFET), organic light emitting diode (OLED) or organic photovoltaic (OPV) device or a component thereof, comprising the step of exposing the OFET, OLED or OPV device or the component to a beam of particles of low energy, thereby depositing a layer of said particles on the electronic device or component, characterized in that
the process for providing said layer does not include a process or process step selected from the group consisting of vapour deposition processes, plasma or ion enhanced deposition processes, or plasma or ion assisted deposition processes,
the deposition step is a direct deposition and the particle beam is a beam of weakly accelerated plasma or ions provided by an end Hall source, and
the predominating particle energy is from 0.1 to 30 eV.

### Brief Description of the Drawings

**Figure 1** schematically illustrates the processes of (a) vapour deposition, (b) sputtering deposition and (c) direct deposition using a particle beam.
**Figure 2** schematically illustrates deposition geometries in a process.
**Figure 3** exemplarily illustrates the construction and working principle of an anode layer source **(a),** and the deposition principle of this source (b).
**Figure 4** exemplarily illustrates the construction and working principle of an end-Hall source **(a),** and the deposition principle of this source (b).
**Figures 5a** and **5b** show the transfer curves of a bottom gate transistor according to Example 1 before and after treatment by plasma deposition.

### Detailed Description of the Invention

The electronic device or component thereof onto which the functional layer is deposited is hereinafter also shortly referred to as the "substrate". As said above, in case of VD used in prior art the particles energy is very low, and typically ranges from 0.001 to 0.01 eV. Because of this, the prior art coatings obtained by VD are usually quite porous and mechanically unstable. Among other reasons, plasma assistance is therefore needed in the VD process to give additional energy to the particles. On the other hand, in case of plasma processes like PECVD, the particles have high energy and reactivity that is harmful for organic electronics.

The present invention provides a simple deposition principle, without the use of additional enhancement or assistance processes, yielding coatings on organic layers with high density, good gas and moisture barrier properties and high mechanical durability.

The process of the present invention is based on a thorough optimization of the kinetic energy of the particles forming a coating on the other OE device layers. On the one hand, this energy should be strong enough to ensure formation of dense and uniform films with good barrier properties with regard to moisture and aggressive gases. On the other hand, the particle energy should be as low as possible to minimize destructive action of the particles. the inventors of the present invention have found that the optimized range of predominating particle energies is from 0.1 to 30 eV. The optimized energy value depends on the type of particles, their reactivity, etc.

This range of particle energies can be achieved by a thorough selection of deposition processes and particle sources. The most suitable processes and sources are discussed below. The further optimization of particle energy can be realized, for example, by changing the distance between the particle source and the substrate or, in other words, the averaged number of collisions of accelerated particle with gas atoms resulting in dissipation of the particles energy. Due to this process, two-order reduction of the particles energy can be attained [see K. Mayer, I. Schuller, and C. Falco, Termalization of Sputtered Atoms. J. Appl. Phys., 52(9), 5803 (1981)].

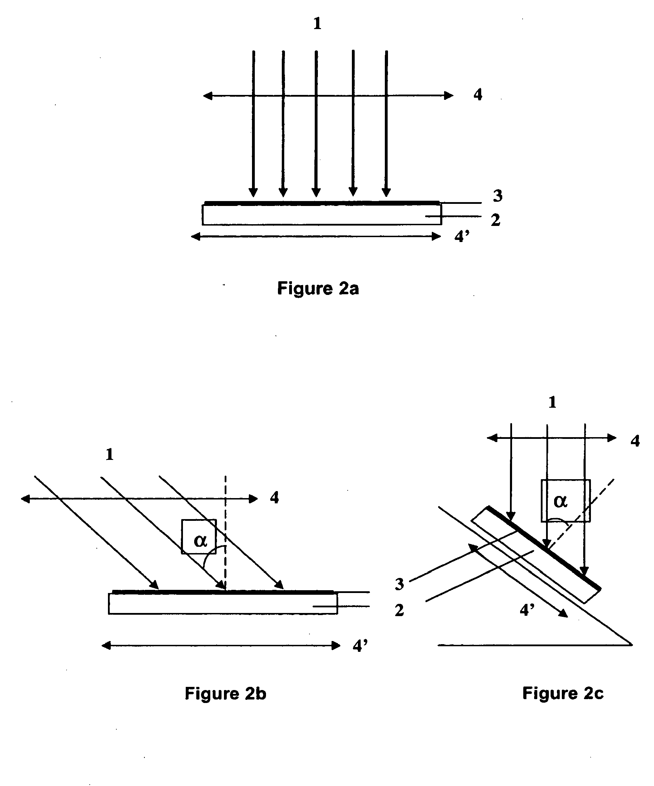

**Figure 2** schematically and exemplarily illustrates the typical deposition geometries. Therein, (1) denotes the particle beam, (2) the substrate, (3) the coated film, and (4) and (4 ') the translation direction of particle beam and substrate, respectively. To produce a passivation or encapsulation coating on an OE layer, a beam of said particles is preferably directed to the organic layer normally, as shown in **Figure 2a****,** or obliquely, as shown in **Figures 2b and 2c****.** In order to produce an aligning layer for organic molecules capable that induces their planar or tilted alignment, the particle beam is preferably directed obliquely. The oblique deposition can be realized in two ways. In the first geometry as shown in **Figure 2c****,** the symmetry axis of the source is oriented vertically, while the substrate and moving platform are set slantwise with regard to the horizontal level. In the second geometry, as shown in **Figure 2b****,** the substrate is translated with the moving platform horizontally, while the source is set in oblique position. The deposition angle α, which is the angle formed by the particle beam and the normal to the substrate surface, is varied preferably from 0° to 85°. The depositions can be provided in static or dynamic regime. The latter case can be realized by translation of a sample or steering particle beam as shown in **Figure 2****.** In case the passivation coating is simultaneously used as an alignment coating for some component of OE device (interior passivation coating) or as alignment layer for liquid crystals in an LC device (external passivation coating or encapsulation coating), it is deposited as alignment coating as described above.

As substrate principally any organic layer, which is usable or used as component or functional layer of an OE device, can be used. These organic layers include, but are not limited to, layers of materials known as hole transport materials, electron transport materials, phosphorescent materials, small molecul materials, polymer materials and the like.

The mentioned range of particle energy can be achieved by several processes, which are completely different from vapour deposition (VD) assisted by plasma or ions as described in prior art.

In one preferred embodiment of the present invention the deposition process is an ion or plasma beam sputtering deposition as schematically presented in **Figure 1** **b.** In this method a beam of moderately accelerated particles (1') (primary beam) causes material ablation from a target (4). The particles (1) extracted from the target form a secondary particle beam directed on the substrate (2). In contrast to the primary beam having a low divergence and a rather high predominating particle energy (usually, several keV), the secondary beam is much more divergent with a predominating particles energy of several eV or tens of eV. These particles effectively condense on the substrate (2) to form a coating (3).

The source of the primary particle beam can be any ion beam or plasma beam source producing moderately accelerated particles capable to knock out particles from a target. Suitable and preferred examples of such sources are the Kaufman type source, anode layer source, hollow cathode source and magnetrons. In case of non-reactive sputtering, the feed gas of the source is a rare gas, usually Ar. In case of reactive sputtering, reactive gases like N₂, O₂, CH₄, CF₄ or, more commonly, mixtures of rare and reactive gases are utilized. In case the feed gas is a pure rare gas, coating is formed only from the target material. In turn, in case the feed gas has reactive components, the coating contains atoms of target and reactive gases in the proportion depending on concentration of reactive gases and processing conditions.

The types of passivation, encapsulation, alignment and other functional films which can be produced by sputtering deposition method include, but are not limited to, metals (Al, Zn, Cu, Ta, Ti, etc.), silicon based materials (Si, SiOₓ, SiNₓ, SiOₓN_{y}, etc.) metal oxides (Al₂O₃, ZnO, Ta₂O₅, TiO₂, etc.), metal nitrides (ZnNₓ, ZrNₓ, etc.), metal oxinitrides (AlOₓN_{y}, TiOₓN_{y}, ZrOₓN_{y}). Along with sputtering of inorganic targets, sputtering deposition techniques can be effectively used to sputter some organic targets. This is especially useful for organic materials which cannot be deposited using traditional wet coating techniques. An example for such a material is Teflon. The structure of the obtained coatings is not well studied yet.

The sputtering deposition provides several advantages, like for example a high adhesion of the deposited coating to the substrate, and a high density of the deposited coating. As a consequence, the process according to the present invention does not need plasma assistance like the prior art methods. Further advantages of the process of the present invention are its high controllability and high reproducibility, and a high coating uniformity.

In an example the process utilizes sputtering deposition wherein the source of the primary particle beam is an anode layer source.

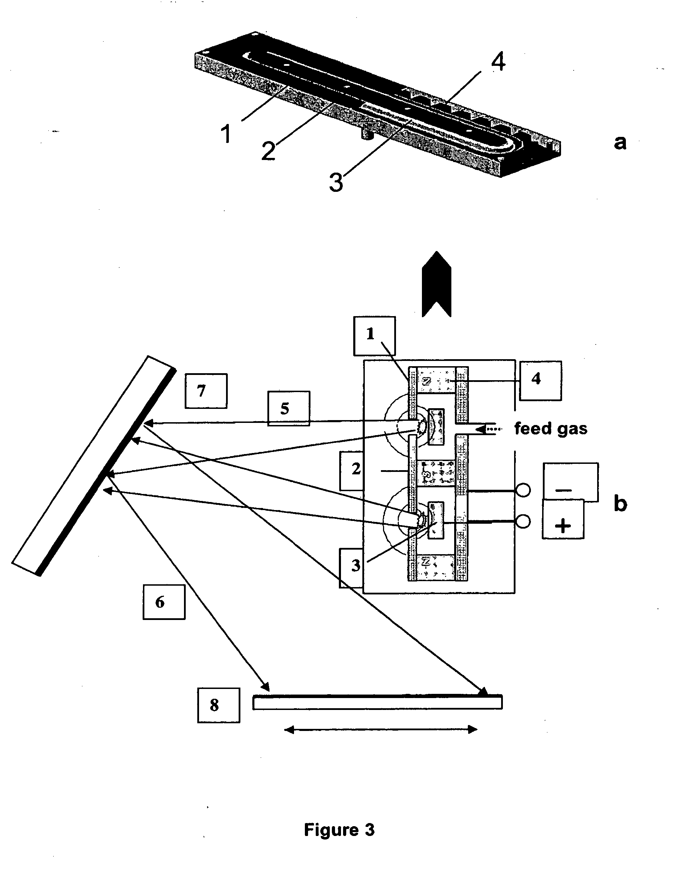

**Figure 3** exemplarily illustrates the construction and working principle of an anode layer source **(a),** and the deposition principle based on this source **(b).** Therein, (1), (2), (3) and (4) denote the inner and outher cathodes, anode and magnet system of the source, respectively, (5) denotes primary particle beam, (6) the secondary particle beam, (7) the target and (8) the substrate with the coated layer.

The source contains permanent magnets (4) on the inner and outer cathodes (1) and (2). The anode (3) is between the cathodes. Together these electrodes define the size and the shape of the discharge channel. Briefly, the working principle is as follows. The electrons from the cathodes drift along the discharge channel as a result of the crossed (mainly radial) magnetic and axial electric fields. The electrons in the closed drift undergo ionizing collisions with the neutrals injected in to the chamber. The magnetic field is strong enough to lock electrons in a drift within a closed discharge channel, while it is not strong enough to affect the trajectory of the ions which are essentially accelerated by the axial electric field. The exhausted ions involve neutrals and electrons. In fact, the formed flux is a part of d.c. plasma generated in the discharge area. For this reason it is often referred to as an accelerated plasma beam rather than an ion beam.

The anode layer source has the advantage of a very simple construction. Another strong advantage of this source, especially when used for OE layers, is the absence of heated elements like a hot cathode. Moreover, in case of sputtering of metallic targets, hot filaments injecting electrons in the beam of accelerated plasma are not needed, too. This substantially reduces the risk of thermal destruction of OE structures. Besides, the anode potential of the source can be tuned so that the energy of primary and, hence, secondary particles can be easily optimized for different OE layers. The sputtering deposition rate of an anode layer source is lower than that of a magnetron. However, its sputtering regime is considerably more tolerate than that of a magnetron. Also, coatings produced by sputtering systems based on anode layer source are characterized by especially good uniformity and high density. Preferably, the source has an elongated construction to process large-area substrates in a scanning regime. The target can be mounted on the body of this source or located separately as shown in **Figure 3****.**

The source is typically mounted in a vacuum chamber. The basic vacuum is < 3x10⁻⁵ Torr (1 Torr = 133 Pa). In the non-reactive sputtering regime the working gas is usually argon. The working pressure P_{Ar}, anode potential Uₐ and discharge current I in this regime are preferably P_{Ar}= 1.0-1.3x10⁻³ Torr, Uₐ=2000-4000 V and I=20-100 mA. In case of reactive gases as well as mixtures of Ar with reactive gases, working parameters are determined by the gases and the desired structure of the coating. Table 1 below shows the content of feed gas and other parameters of the source typically used to deposite different kinds of coatings.

**Table 1**

| Preparation Coating | Component of gaseous mixture/ partial pressure [Torr] | Uₐ [kV] | I [mA] | Target |
|---|---|---|---|---|
| SiO₂ | Ar/1.1 10⁻³ | 4.0 | 60 | SiO₂ |
| SiOₓ | O₂/ 5*10⁻⁴, Ar/6.5*10⁻⁴ | 3.2 | 44 | Si |
| SiNₓ | N₂/4*10⁻⁴, Ar/6*10⁻⁴ | 3.5 | 47 | Si |
| TaOₓ | O₂/4*10⁻⁴, Ar/5.8*10⁻⁴ | 2.8 | 48 | Ta |
| AlOₓ | O₂/4 10⁻⁴; Ar/6.0 10⁻⁴ | 3.0 | 50 | Al |

In another example, the process using a beam of particles with a certain range of energies is direct ion or plasma beam deposition. In this deposition process particle beams necessarily include reactive particles that are capable of forming links to the coating layer. The sources generating beams of such particles include but are not limited to the above mentioned anode layer source and hollow cathode source working with reactive gaseous feed (see, for exaple, [V. Dudnikov and A. Westner, "Ion source with closed drift anode layer plasma acceleration". Review of Scientific Instruments, 73 (2), 729 (2002)]. The predominating particle energy in the direct deposition process is usually within 10 and 300 eV depending on particle source, kind of gaseous feed, coating requirements, etc.

The types of passivation, encapsulation, alignment and other functional films, which can be produced by the sputtering deposition method include, but are not limited to, SiOₓ, SiOₓN_{y}, SiNₓ, SiCₓH_{y}, a-CH, a-CHN, a-CHF.

The direct particle beam deposition has number of advantages compared with the other deposition methods. It is technologically a very simple process. Thus, for example a target is not needed. A low voltage operation diminishes the amount of parasitic discharges "dusting" the working area due to particle generation. The direct deposition technique provides amorphous coatings, which are commonly more uniform than in case of sputtering deposition. The particle beam formed by the plasma/ion beam source is more collimated than a particle flux sputtered from a target. This enables better fine patterning of the deposited films. Finally, the content of the deposited films can be continuously changed by the variation of relative content of gases forming feed gaseous mixture. This allows to vary continuously the composition and structure of the layer.

Moreover, by using direct plasma or ion beam deposition as described for the preparation of inorganic layers for OE devices, it is possible to avoid the problems that could be caused when using plasma treatments according to the usual prior art methods.

For example, the prior art methods of plasma generation as disclosed in Sprokel and Gibson J.Electrochem.Soc., 124 (4), 557 (1977) and US 4,261,650, do only produce fluxes of cold r.f. (radio frequency generated) plasma, which have a particle energy of only several meV (milli eV), and are carried to the substrate by a gas stream. Because of these conditions the coatings formed poorly adhere to substrate, are porous, friable and mechanically undurable. On the other hand, a direct deposition process, due to temperate, particles energy and reactivity, is not as aggressive for OE layers as "enhanced" plasma processes widely used in the prior art.

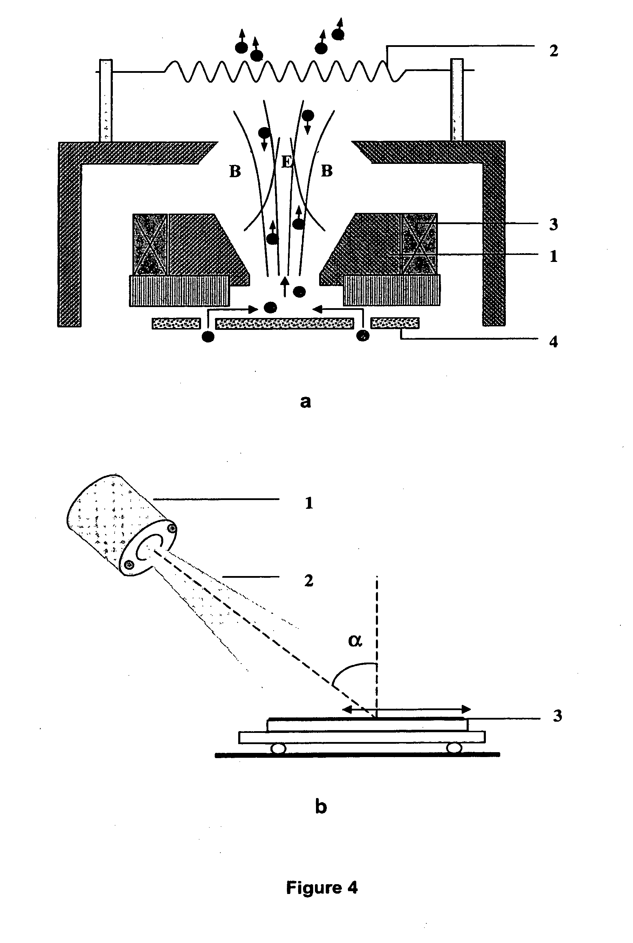

In the embodiment of the direct particle deposition a source known as an end Hall plasma beam source from the family of Hall sources, as disclosed for example in US 4,862,032, is used, as schematically and exemplarily shown in **Figure 4****.** In **Figure 4a****,** (1), (2), (3), and (4) denote the anode, cathode, electromagnet system and gas inlet, respectively. In **Figure 4b****,** (1), (2) and (3) mark the source, plasma beam and substrate, respectively.

The source consists of an anode (1) beyond which a cathode (2) is spaced. On the anode is placed an electromagnet winding (3). In the scheme, neutral particles (atoms, molecules), electrons and ions are indicated, respectively, by "0", "-" and "+". Neutral particles of the working gas are introduced to the ion source through the inlet (4).

The end-Hall source also allows sufficient modifications. For example, the electro-magnet system can be replaced by permanent magnets. Also, same as the anode layer source, the end-Hall source can be arranged to form a linear version [see J. Madocks, Proceeding of 45th Annual Technical Conference of Society of Vacuum Coaters, Orlando, USA. p. 202 (2002)]. This allows to extend the disclosed method for the large-area substrates and to realize roll-to-roll processing of plastic strips.

The end-Hall source works as follows: Electrons emitted by the hot cathode are attracted by the anode being under a potential Uₐ. Approaching the anode, they approximately follow magnetic field lines. Accelerated electrons strike neutrals causing their ionization. Most of the ionizing collisions occur near the anode. The generated ions accelerate toward the cathode. These ions have a broad energy distribution with the maximum at 2/3(eUₐ). Leaving the source, the ions involve some electrons forming a neutralized beam. Because the beam is formed immediately in the glow discharge, it can be considered as a portion of plasma extracted and accelerated by the anode potential.

The important advantage of the end-Hall source is that, further to deposition, it can also work in a pre-cleaning regime. The pre-cleaning usually precedes deposition to ensure good adhesion of the produced coating to substrates.

The source is typically mounted in a vacuum chamber. The basic vacuum is < 3x10⁻⁵ Torr. In the pre-cleaning regime, the working gas is usually argon. The working pressure P_{Ar}, anode potential Uₐ and discharge current I in this regime are preferably P_{Ar}= 6-8x10⁻⁴ Torr, Uₐ=110-150 V and I=1.0-2.0 A. In the deposition regime, a mixture of reactive gases or reactive and rare gases is used as a gas feed. The working pressure P in this regime is preferably P=0.8-3x10⁻³ Torr, while the anode potential Uₐ and discharge current I are preferably Uₐ=50-100 V and I=1-5 A. The deposition time is typically 1-5 min, depending on the material, current and coating thickness measured by the quartz-crystal controller.

The depositions are carried out in normal and oblique geometries as shown in **Figure 2****.** The films are deposited in either static or moving regime.

The typical processing parameters corresponding to some types of coatings are summarized in Table 2.

**Table 2**

| Preparation Coating | Component of gaseous mixture/ partial pressure [Torr] | Uₐ [V] | I [A] |
|---|---|---|---|
| a-SiOₓ | SiH₄/2 10⁻³; O₂/3.5 10⁻⁴ | 60 | 4 |
| a-CH | CH₄/1.2*10⁻³; O₂/0.7*10⁻⁴ | 90 | 2 |
| a-CHN | CH₄/1.3*10⁻³, N₂/0.7*10⁻⁴ | 80 | 2 |
| a-CHF | CH₄/1.2*10⁻³, CF₄/0.8*10⁻⁴ | 90 | 2 |

By using a process according to the invention, the deposition of passivation/encapsulation layers can also be provided on rollable plastic substrates in a roll-to-roll translation. This is an important advantage when preparing flexible OE devices. In this case the particle beam processing is provided during roll-to-roll rewinding of a plastic strip. This roll can then be subsequently subjected to further processing steps if necessary.

The sources of Hall family preferably used in this invention can be worked in pulsed regime. This may further soften processing conditions reducing the risk of damage of OE layers and plastic substrates on which OE devices are constructed.

In addition, patterned layers (i.e. a pattern of regions with different structure or composition) can be realized by the use of masks and multiple deposition or deposition and etching steps.

The method according to the present invention is also compatible with other vacuum processes employed in OE industry, including but not limited to, vapour deposition, TFT coating, etc. This can be advantageously used in an entirely vacuum technological line of OE device production, which can strongly reduce the well-known problems related to dust, humidity, air ions etc.

Especially preferred embodiments of the present invention are the following:
- the deposited layer comprises or consists of a material selected from the group consisting of SiOₓ, SiNₓ, SiOₓN_{y}, SiNₓH_{y}, Al₂O₃, Al₂O₃:N (small amount of N), TiO₂, TiO₂:N (small amount of N), ZrO₂, ZrO₂:N (small amount of N), Ta₂O₅, Ta₂O₅:N (small amount of N), a-C:H, a-C:H:N.
- the deposition is carried out in one step, wherein the processing parameters, in particular the particles energy, are unchanged during deposition of the functional layer.
- the process comprises two deposition steps: a first deposition step is applied using particles of low energy, <10 eV (which is more friendly for the OE structure), then a second deposition step is applied using particles of higher energy, >10 eV (forming a denser coating with better barrier properties). The particle energy can be controlled by varying the accelerating potential of the source and the distance between the source and the substrate.

The claimed process is based on an end Hall source. Possible conditions of this process are:
- the particle beam in the deposition step is generated from a reactive gas or a mixture of two or more reactive gases, preferably selected from the group consisting of SiH₄, N₂, O₂, H₂. The working gaseous mixture may also contain rare gases such as Ar, Kr, Xe, which mainly serve as gas carriers for reactive components and assist deposition of reactive components.
- the working pressure in the deposition step is from 0.5x10⁻³ to 3x10⁻³ Torr, depending on the gaseous mixture,
- the anode potential in the deposition step provides a predominating particle energy from 0,1 to 30 eV,
- the discharge current in the deposition step is from 1 to 4 A,
- the substrate is set at a distance >10 cm from the discharge area of the anode layer source and 10 to 100 cm from the target. The latter distance can be varied in the two-step deposition process to change the energy and density of particles forming a functional coating,
- the deposition time is 0.25 to 3 min, in order to to get coatings with a preferred thickness from 10 to 100 nm,
- the deposition of the layer is provided in normal or oblique geometry, i.e. with a deposition angle α being 0° or different from 0°, respectively. In case the functional layer is a not claimed alignment layer, it is preferably deposited obliquely, i.e. from an deposition angle α ≠ 0°. To provide an in-plane alignment function, the deposition angle α is preferably from 60° to 85° (α is the angle relative to the film normal),
- the process further comprises the step of utilizing a mask to prevent the plasma beam from reaching a predetermined portion of the substrate, for example by applying a mask to the substrate before or during plasma beam exposure,
- the layer is prepared by sputtering or direct particle beam deposition on a continuously moving substrate, preferably a flexible plastic substrate, that is provided or unwound from a roll in a continuous or roll-to-roll process.

The present invention is described above and below with particular reference to the preferred embodiments. It should be understood that various changes and modifications may be made therein without departing from the invention as claimed.

The protection layers used for illustration in the examples below do not limit the variety of films which can be deposited by the sputtering and direct deposition methods and used for the passivation purpose. Many other examples of coatings were presented above. Besides, so named plasma polymer coatings prepared under low energy flux can be used for this purpose [see, for example, H. Biederman et al., Surf. And Coat. Technol., 125, 371 (2000)].

The invention presumes that along with single protection layers multiple protection layers can be produced using the same or different techniques disclosed in this invention or using at least one technique of this invention in combination with other coating techniques.

The following examples are illustrative only.

### Example 1

Two bottom gate organic thin film transistors (OTFT) with poly[(2,4-dimethylphenyl)-diphenyl amine] (PTAA) as semiconductor are fabricated on OTS treated Si/SiO₂ substrates with photolithographically defined gold source/drain electrodes, by spin coating a 4% solution of the polymer in Tetralin. The resulting film is dried at 100°C for 10min, and allowed to cool to room temperature.

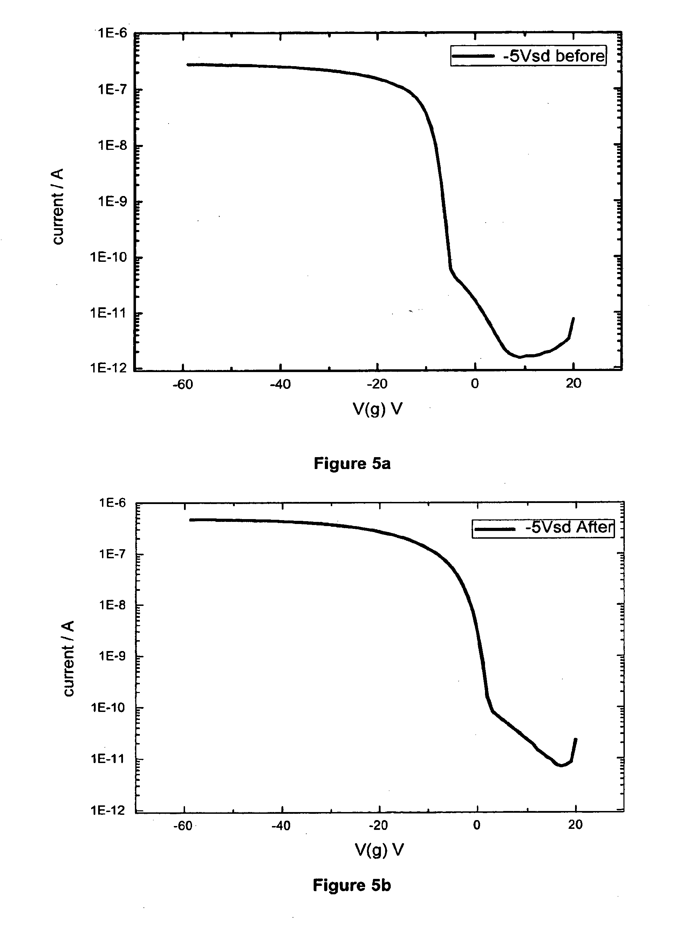

After preparation the transfer curves of these transistors are measured. The curves measured for two devices are practically identical. The curve of the testing sample further subjected to passivation is shown in **Fig. 5a**.

Within 7 days the testing sample is processed for encapsulation, while a second, reference sample, is stored at ambient conditions. The passivation is provided by a sputtering deposition technique based on anode layer source. The basic vacuum in a vacuum chamber is 3.5x10⁻⁵ Torr. The feed gas is argon. The working pressure of Ar is 1.1x10⁻³ Torr. The anode potential of the source is 2.5 kV and the discharge current is 80 mA. The target material is fused quartz. The accelerated plasma flux from the anode layer source is directed to target plate placed on the distance of about 12 cm from the source. A secondary particle beam formed from the target atoms impinged obliquely on substate with organic device. The incidence angle is about 60°. The distance between the substrate and the target is about 60 cm. The deposition time is 8 min, which results in a thickness of the SiO₂ coating of about 50 nm. During deposition, the contacts of o-TFT are protected from depositing particles by mask.

After deposition, the transfer curve for the testing sample is measured again. The curve is shown in **Figure 5b****.** It can be seen that the curves before and after plasma deposition process are very similar. In both cases they are good working devices. The mobility is shown in Table 2 below.

**Table 2**

| | **Mobility [cm²/Vs]** |
|---|---|
| **Before treatment 5A** | 1x10⁻³ |
| **After treatment 5B** | 1x10⁻³ |

The transfer curves of testing (encapsulated) and reference (non-encapsulated) samples were periodically measured over 6 months after preparation. The parameters of the encapsulated device persisted over the whole time of monitoring (10 % deterioration for 6 months), while the performance of reference sample gradually deteriorated. Two months after preparation the switching contrast of this device was 400 times worse than just after preparation. This shows the high efficiency of the encapsulation.

### Example 2

A bottom gate OTFT is prepared as in Example 1 and its transfer characteristic is measured. As in Example 1, encapsulation of the OTFT is provided by a sputtering deposition technique based on an anode layer source. In contrast to the deposition in Example 1, the target is a silicon wafer, while the feed gas is a mixture of Ar (partial pressure 6.5*10⁻⁴ Torr) and O₂ (partial pressure 5*10⁻⁴ Torr). The anode potential is 3.2 kV and the discharge current is 85 mA. The deposition time is 15 min, which corresponds to a thickness of the SiOₓ layer formed on the OTFT of about 100 nm. After deposition the transfer function of the device is measured again. The switching contrast after deposition is 4 times worse than before deposition. This encapsulated device shows aging stability comparable to that of the passivated device in Example 1.

### Example 3

A glass substrate with an OTFT prepared as in Example 1 is encapsulated as in Example 1. A second glass substrate with an ITO electrode is coated with an SiO₂ layer as the substrate with the OTFT. Using these two substrates and 9 µm spacers between them a cell is assembled so that deposition directions on the opposing substrates are antiparallel. The cell is glued with epoxy glue and filled with the nematic LC mixture MLC-6608 (from Merck KGaA) at room temperature. The LC molecules demonstrate tilted vertical alignment with a pretilt angle 89.2°. Thus, the encapsulation layer can in addition serve as aligning layer for liquid crystal materials. If a liquid crystal material is used as semiconductor in organic electronic devices, the enhanced uniform orientation of the liquid crystal material can enhance its charge carrier properties and thereby improve the transistor performance.

## Claims

1. Process of providing a protection, passivation or encapsulation layer on an organic field effect transistor (OFET), organic light emitting diode (OLED) or organic photovoltaic (OPV) device or a component thereof, comprising the step of exposing the OFET, OLED or OPV device or the component to a beam of particles of low energy, thereby depositing a layer of said particles on the organic electronic device or its component, **characterized in that**
the process for providing said layer does not include a process or process step selected from the group consisting of vapour deposition processes, plasma or ion enhanced deposition processes, or plasma or ion assisted deposition processes,
the deposition step is a direct deposition and the particle beam is a beam of weakly accelerated plasma or ions provided by an end Hall source, and
the predominating particle energy is from 0.1 to 30 eV.

2. Process according to claim 1, **characterized in that** the device or its component is exposed to the beam of particles through a mask.

3. Process according to claim 1 or 2, **characterized in that** the layer comprises or consists of a material selected from the group consisting of SiOₓ, SiNₓ, SiOₓN_{y}, SiNₓH_{y}, Al₂O₃, Al₂O₃:N (small amount of N), TiO₂, TiO₂:N (small amount of N), ZrO₂, ZrO₂:N (small amount of N), Ta₂O₅, Ta₂O₅:N (small amount of N), a-C:H, a-C:H:N.

4. Process according to one or more of claims 1 to 3, **characterized in that** the layer is deposited in one step with unchanged particles energy.

5. Process according to one or more of claims **1** to **3**, **characterized in that** the layer is deposited in two steps, wherein in the first step the predominating particles energy is <10 eV, and in the second step the predominating particles energy is >10 eV.

## Patentansprüche

1. Verfahren zum Bereitstellen einer Schutz-, Passvierungs- oder Einkapselungsschicht auf einem organischen Feldeffekttransistor (field effect transistor - OFET), einer organischen Leuchtdiode (organic light emitting diode - OLED) oder einer organischen Photovoltaik(OPV)-Vorrichtung oder einer Komponente hiervon, mit dem Schritt, dass man den OFET, die OLED oder die OPV-Vorrichtung oder die Komponente einem Strahl von niedrigenergetischen Teilchen aussetzt, wodurch eine Schicht der besagten Teilchen auf der organischen Elektronikvorrichtung oder ihrer Komponente abgeschieden wird, **dadurch gekennzeichnet, dass**
das Verfahren zum Bereitstellen der besagten Schicht kein Verfahren bzw. keinen Verfahrensschritt umfasst, das/der aus der Gruppe bestehend aus Dampfabscheideverfahren, plasma- oder ionenverstärkten Abscheideverfahren oder plasma- oder ionenunterstützten Abscheideverfahren ausgewählt ist,
es sich bei dem Abscheideschritt um eine direkte Abscheidung und bei dem Teilchenstrahl um einen Strahl von schwach beschleunigtem Plasma oder schwach beschleunigten Ionen handelt, der durch eine End-Hall-Quelle bereitgestellt wird, und
die vorherrschende Teilchenenergie von 0,1 bis 30 eV beträgt.

2. Verfahren nach Anspruch 1, **dadurch gekennzeichnet, dass** die Vorrichtung oder ihre Komponente dem Teilchenstrahl durch eine Maske ausgesetzt wird.

3. Verfahren nach Anspruch 1 oder 2, **dadurch gekennzeichnet, dass** die Schicht ein Material, das aus der Gruppe bestehend aus SiOₓ, SiNₓ, SiOₓN_{y}, SiNₓH_{y}, Al₂O₃, Al₂O₃:N (kleine Menge N), TiO₂, TiO₂:N (kleine Menge N), ZrO₂, ZrO₂:N (kleine Menge N), Ta₂O₅, Ta₂O₅:N (kleine Menge N), a-C:H, a-C:H:N ausgewählt ist, enthält oder daraus besteht.

4. Verfahren nach einem oder mehreren der Ansprüche 1 bis 3, **dadurch gekennzeichnet, dass** die Schicht in einem Schritt mit unveränderter Teilchenenergie abgeschieden wird.

5. Verfahren nach einem oder mehreren der Ansprüche 1 bis 3, **dadurch gekennzeichnet, dass** die Schicht in zwei Schritten abgeschieden wird, wobei im ersten Schritt die vorherrschende Teilchenenergie bei < 10 eV und im zweiten Schritt die vorherrschende Teilchenenergie bei > 10 eV liegt.

## Revendications

1. Procédé d'application d'une couche de protection, de passivation ou d'encapsulage sur un dispositif de transistor à effet de champ organique (OFET), un dispositif de diode émettrice de lumière organique (OLED) ou un dispositif photovoltaïque organique (OPV) ou un composant afférent, comprenant l'étape consistant à exposer le dispositif OFET, OLED ou OPV ou le composant à un faisceau de particules de basse énergie, d'où ainsi le dépôt d'une couche desdites particules sur le dispositif électronique organique ou sur son composant, **caractérisé en ce que** :
le procédé d'application de ladite couche n'inclut pas un procédé ou
une étape de procédé choisi(e) parmi le groupe constitué par des procédés de dépôt en phase vapeur, des procédés de dépôt rehaussé par plasma ou ions ou des procédés de dépôt assisté par plasma ou ions;
l'étape de dépôt est un dépôt direct et le faisceau de particules est un faisceau de plasma ou d'ions faiblement accéléré(s) fourni par une source « end-Hall » ; et
l'énergie des particules prédominante est de 0,1 à 30 eV.

2. Procédé selon la revendication 1, **caractérisé en ce que** le dispositif ou son composant est exposé au faisceau de particules au travers d'un masque.

3. Procédé selon la revendication 1 ou 2, **caractérisé en ce que** la couche comprend ou est constituée par un matériau choisi parmi le groupe constitué par SiOₓ, SiNₓ, SiOₓN_{y}, SiNₓH_{y}, Al₂O₃, Al₂O₃:N (une faible quantité de N), TiO₂, TiO₂:N (une faible quantité de N), ZrO₂, ZrO₂:N (une faible quantité de N), Ta₂O₅, Ta₂O₅:N (une faible quantité de N), a-C:H, a-C:H:N.

4. Procédé selon une ou plusieurs des revendications 1 à 3, **caractérisé en ce que** la couche est déposée en une seule étape sans modifier l'énergie des particules.

5. Procédé selon une ou plusieurs des revendications 1 à 3, **caractérisé en ce que** la couche est déposée en deux étapes, dans lequel, lors de la première étape, l'énergie des particules prédominante est
< 10 eV et lors de la seconde étape, l'énergie des particules prédominante est > 10 eV.
